# EUROPÄISCHE PATENTSCHRIFT

(11) **EP 2 891 222 B1**
(45) Veröffentlichungstag und Bekanntmachung des Hinweises auf die Patenterteilung: **06.01.2016**
(21) Anmeldenummer: 12784473.6
(22) Anmeldetag: 10.10.2012
(51) Int. Cl.: H02J 3/24

(54) **VERFAHREN UND DATENVERARBEITUNGSANORDNUNG FÜR DIE BESTIMMUNG VON FREQUENZ, AMPLITUDE UND DÄMPFUNG MINDESTENS EINER LEISTUNGSPENDELUNG IN EINEM ELEKTRISCHEN ENERGIEVERSORGUNGSNETZ**
METHOD AND DATA PROCESSING ARRANGEMENT FOR DETERMINING THE FREQUENCY, AMPLITUDE AND ATTENUATION OF AT LEAST ONE OUTPUT OSCILLATION IN AN ELECTRICAL ENERGY SUPPLY NETWORK
PROCÉDÉ ET DISPOSITIF DE TRAITEMENT DE DONNÉES POUR LA DÉTERMINATION DE LA FRÉQUENCE, DE L'AMPLITUDE ET DE L'AMORTISSEMENT D'AU MOINS UNE OSCILLATION DE PUISSANCE DANS UN RÉSEAU D'ALIMENTATION EN ÉNERGIE ÉLECTRIQUE

(43) Veröffentlichungstag der Anmeldung: 08.07.2015
(73) Patentinhaber: Siemens Aktiengesellschaft, 80333 München (DE)
(72) Erfinder: LITZINGER, Andreas, 90765 Fürth (DE); PIEL, Stefan, 45359 Essen (DE)
(86) Internationale Anmeldenummer: PCT/EP2012/070006
(87) Internationale Veröffentlichungsnummer: WO 2014/056531

(56) Entgegenhaltungen:
- MARK GLICKMAN ET AL: "Estimation of Modal Damping in Power Networks", IEEE TRANSACTIONS ON POWER SYSTEMS, IEEE SERVICE CENTER, PISCATAWAY, NJ, US, Bd. 22, Nr. 3, 1. August 2007 (2007-08-01) , Seiten 1340-1350, XP011189250, ISSN: 0885-8950, DOI: 10.1109/TPWRS.2007.901122

## Beschreibung

Verfahren und Datenverarbeitungsanordnung für die Bestimmung von Frequenz, Amplitude und Dämpfung mindestens einer Leistungspendelung in einem elektrischen Energieversorgungsnetz

Gegenstand der vorliegenden Erfindung sind ein Verfahren und Anordnung für die Bestimmung von Frequenz, Amplitude und Dämpfung mindestens einer Leistungspendelung in einem elektrischen Energieversorgungsnetz.

Innerhalb von elektrischen Energieversorgungsnetzen, beispielsweise in oder zwischen verschiedenen miteinander verbundenen elektrischen Hochspannungsnetzen, können aufgrund von Wechselwirkungen zwischen Energieerzeugern und Verbrauchern Leistungspendelungen auftreten. Solche Leistungspendelungen können in ihrer Stärke bzw. Amplitude über die Zeit zu- oder abnehmen. Bei abnehmenden Pendelungen wird häufig auch von gedämpften Leistungspendelungen gesprochen. Treten zur gleichen Zeit mehrere Leistungspendelungen auf, so können sich diese überlagern.

Leistungspendelungen z.B. in elektrischen Hochspannungsnetzen können bei hinreichend großer Amplitude zum Ausfall von Teilen oder der Gesamtheit des Netzes führen und damit zu einer schwerwiegenden Störung der elektrischen Energieversorgung führen. Bei Leistungspendelungen ist für das rechtzeitige Einleiten von Gegenmaßnahmen eine möglichst frühzeitige Kenntnis der aktuellen Pendelamplituden und ihrer zeitlichen Entwicklung von großer Bedeutung. Insbesondere ist es für ein Einleiten eventueller Gegenmaßnahmen wichtig zu wissen, ob die Leistungspendelung über die Zeit noch zunimmt. Solchenfalls ist von einer besonderen Gefahr für die elektrische Energieversorgung auszugehen.

Die Kenngrößen einer Leistungspendelung, namentlich Frequenz, Dämpfung und Amplitude, können prinzipiell nicht aus der Messung zu einem einzelnen Zeitpunkt ermittelt werden, sondern erfordern vielmehr die Betrachtung über einen endlichen Zeitraum hinweg.

In den gängigen Verfahren des Standes der Technik werden daher die Messdaten wie z.B. Zeigerinformationen der Spannung und der Stromstärke an einem oder mehreren Punkten des Energieversorgungsnetzes mit einer hohen zeitlichen Auflösung erhoben. Dies kann beispielsweise mittels Phasormesseinrichtungen, sogenannten "Phasor Measurement Units (PMUs)" erfolgen. Aus den Messdaten werden die Momentanwerte der Leistung bestimmt.

Die Messdaten werden über ein zuvor festgelegtes Zeitfenster aufgenommen, um den resultierenden Datensatz anschließend zur Bestimmung der die jeweilige Leistungspendelung beschreibenden Kenngrößen nach verschiedenen, bekannten Verfahren gezielt weiterzuverarbeiten. Durch Wiederholung der Auswertung für die jeweils aktuellen Daten mit einer gegenüber dem Zeitfenster kleinen Zykluszeit ("Sliding Window"-Technik) werden die Ergebnisse in entsprechend kurzen Abständen aktualisiert.

Aus der Veröffentlichung "Damping estimation of electric disturbances in distributed power systems" von Mark Glickmann und Peter O'Shea, erschienen 2005 in Proceedings of the 7th IASTED International Conference on Signal and Image Processing, ist es bekannt, ein Sliding Window Verfahren zur Bestimmung von Frequenz, Amplitude und Dämpfung mindestens einer Leistungspendelung in einem elektrischen Energieversorgungsnetz zu verwenden.

Es ist die Aufgabe der Erfindung, ein gegenüber dem Stand der Technik verbessertes, insbesondere ein genaueres und schnelleres Verfahren für die Bestimmung von Frequenz, Amplitude und Dämpfung mindestens einer Leistungspendelung in einem elektrischen Energieversorgungsnetz bereit zu stellen.

Die Erfindung löst diese Aufgabe durch ein Verfahren für die Bestimmung von Frequenz, Amplitude und Dämpfung mindestens einer Leistungspendelung in einem elektrischen Energieversorgungsnetz, bei dem ein Zeitfenster von vorgegebener Dauer verwendet wird, und innerhalb des Zeitfensters erfasste Momentanwerte der Leistung zur Bestimmung von Frequenz, Amplitude und Dämpfung der mindestens einen Leistungspendelung verwendet werden, dadurch, dass mindestens ein weiteres Zeitfenster verwendet wird, wobei alle Zeitfenster jeweils verschiedene Dauern aufweisen; zur Bestimmung von Frequenz, Amplitude und Dämpfung wird jeweils dasjenige Zeitfenster benutzt, in dessen Dauer eine vorgegebene Anzahl von Pendelvorgängen der jeweiligen Leistungspendelung fällt.

Grundidee der Erfindung ist es also, durch die Verwendung mehrerer Zeitfenster unterschiedlicher Dauer eine genauere und schnellere Bestimmung der Kenngrößen der einen oder mehrerer Leistungspendelungen möglich zu machen, als wenn nur ein einzelnes Zeitfenster verwendet würde.

Das erfindungsgemäße Verfahren ist gegenüber dem Stand der Technik vorteilhaft, weil es gestattet, anders als bei bekannten Verfahren, durch die Verwendung mehrerer Zeitfenster die Dauer der mehreren Zeitfenster auf eine einzelne oder sogar mehrere Leistungspendelungen mit gegebener Frequenz optimal abzustimmen.

So nimmt bei zu niedrigen Frequenzen der Leistungspendelungen die Genauigkeit der bestimmten Kenngrößen ab, da im erfassten Zeitfenster die Anzahl der verfügbaren Leistungspendelungs-Perioden, in erster Näherung durch sinusförmige Wellen charakterisierbar, immer geringer wird. Hierdurch wird die relative Genauigkeit der Bestimmung der Kenngrößen vermindert. Im Grenzfall, in dem weniger als eine einzelne Leistungspendelungs-Periode in dem Zeitfenster erfasst wird, ist eine verlässliche Auswertung grundsätzlich nicht mehr möglich. Da bei dem erfindungsgemäßen Verfahren mehrere Zeitfenster eingesetzt werden, kann stets ein Zeitfenster mit einer ausreichenden Dauer zur Bestimmung der Kenngrößen benutzt werden. Auf der anderen Seite liegt bei höheren Frequenzen der Leistungspendelungen eine nicht verwertbare Überinformation vor. Die in dem Zeitfenster enthaltenen Messdaten umfassen dann eine zunehmende Anzahl von Leistungspendelungs-Perioden aus der Vergangenheit, die jedoch keinen zusätzlichen Informationsgewinn bereitstellen. Darüber hinaus tritt der Effekt auf, dass bei einer relativ zu den hohen Frequenzen der Leistungspendelungen geringen Dauer des Zeitfensters und/oder infolge des mit wachsender Dauer des Zeitfensters immer größer werdenden historischen Datenanteils die aktuellen Ergebnisse zunehmend verfälschen. Beim erfindungsgemäßen Verfahren kann hier in vorteilhafter Weise ein Zeitfenster benutzt werden, das ausreichend klein ist, um den historischen Datenanteil klein zu halten.

Somit erlaubt die Verwendung mehrerer Zeitfenster, jeweils mehrfach und gleichzeitig die Kenngrößen der Leistungspendelungen zu bestimmen. Dabei ist es ein Vorteil, dass jeweils dasjenige Zeitfenster zur schlussendlichen Bereitstellung der Kenngrößen ausgewählt werden kann, dessen Dauer am Besten zu der Frequenz der Leistungspendelung passt. Bei mehreren Leistungspendelungen, die gleichzeitig vorkommen, können entsprechend mehrere geeignete Zeitfenster ausgewählt werden. Das bzw. die ausgewählten Zeitfenster enthalten keine Überinformation und gewährleisten daher, dass die Bestimmung der Kenngrößen der Leistungspendelungen schnellstmöglich erfolgt. Die Kenngrößen werden daher besonders schnell einer Leitstelle des Energieversorgungsnetzes zur Verfügung gestellt und erlauben ein schnelles Einleiten von Gegenmaßnahmen bei gefährlichen Leistungspendelungen. Das schnelle Einleiten von Gegenmaßnahmen verringert die Gefahr von Ausfällen oder anderen Störungen des Energieversorgungsnetzes, was Kosten spart und die Kundenzufriedenheit erhöht.

Gleichzeitig erhöht das erfindungsgemäße Verfahren auch die Genauigkeit der Bestimmung der Kenngrößen der Leistungspendelungen, weil durch das Vermeiden von Überinformationen der historische Anteil der Messdaten bei der Bestimmung der Kenngrößen klein bleibt. Durch die so herbeigeführte hohe Aktualität der Bestimmung der Kenngrößen ist sichergestellt, dass die Kenngrößen die Leistungspendelungen besonders genau charakterisieren.

In einer bevorzugten Ausführungsform des erfindungsgemäßen Verfahrens weisen die Zeitfenster jeweils eine auf typische Frequenzen von Leistungspendelungen abgestimmte Dauer auf. Dies ist vorteilhaft, weil bei Kenntnis von in dem jeweiligen elektrischen Energieversorgungsnetz häufig vorkommenden Leistungspendelungen diese Information genutzt werden kann, um das Verfahren von vorneherein optimal abzustimmen, was eine größtmögliche Genauigkeit und Schnelligkeit bei der Bestimmung der Kenngrößen der Leistungspendelungen sicherstellt.

In einer vorteilhaften Weiterbildung der vorgenannten Ausführungsform des erfindungsgemäßen Verfahrens ist die vorgegebene Anzahl die jeweils zur Bestimmung gerade noch ausreichende Anzahl von Pendelvorgängen der jeweiligen Leistungspendelung. Hierdurch wird es erreicht, dass dasjenige Zeitfenster benutzt wird, dessen Dauer gerade lang genug ist, um eine zuverlässige Bestimmung der Kenngrößen zu gewährleisten. Gleichzeitig ist sichergestellt, dass das benutzte Zeitfenster so klein wie möglich ist, um den historischen Teil der erfassten Momentanwerte klein zu halten und eine schnelle und genaue Bestimmung der Kenngrößen sicher zu stellen. Unter einem Pendelvorgang ist dabei eine vollständige Schwingung, also z.B. ein Schwingungsvorgang von maximaler Amplitude zu maximaler Amplitude, zu verstehen. Ein Pendelvorgang schließt folglich zwei sogenannte Halbwellen ein. Theoretisch können die Kenngrößen bereits aus einem einzigen Pendelvorgang mit zwei Halbwellen abgeschätzt werden. Um eine zuverlässige Bestimmung der Kenngrößen zu gewährleisten, werden in der Praxis aber beispielsweise zwischen 4 und 10 Pendelvorgängen in dem jeweiligen Zeitfenster ausgewertet.

In einer weiteren bevorzugten Ausführungsform des erfindungsgemäßen Verfahrens werden die erfassten Momentanwerte in einem Speicher mit einer Speicherplatzgröße gespeichert, die das Speichern der im längsten Zeitfenster erfassten Momentanwerte gestattet. Diese Ausführungsform ist von Vorteil, weil nur ein Speicher bereit gehalten wird, dessen Speicherplatzgröße gerade ausreichen muss, um die im längsten Zeitfenster erfassten Momentanwerte zu sichern. Da alle Zeitfenster, auch die Zeitfenster mit kürzerer Dauer als das längste Zeitfenster, auf den gleichen Speicher zugreifen, ist nur ein Speicher nötig. Der Speicher kann beispielsweise als ein Ringspeicher ausgebildet sein.

In einer weiteren bevorzugten Ausführungsform des erfindungsgemäßen Verfahrens wird die Bestimmung von Amplitude und Dämpfung regelmäßig zu vorgegebenen Zeitpunkten wiederholt. Dies ist vorteilhaft, weil die Bestimmung ständig aktualisiert wird und stets aktuelle Kenngrößen der Leistungspendelungen in dem elektrischen Energieversorgungsnetz bereit gestellt werden. Auf diese Weise erhält beispielsweise eine Leitstelle stets aktuelle Informationen über Leistungspendelungen in ihrem Energieversorgungsnetz und kann dementsprechend handeln.

In einer bevorzugten Weiterbildung der vorgenannten Ausführungsform des erfindungsgemäßen Verfahrens wird, wenn bereits mindestens eine Leistungspendelung erkannt wurde, der zeitliche Abstand der vorgegebenen Zeitpunkte verringert wird, wenn die erkannte mindestens eine Leistungspendelung eine hohe Frequenz aufweist. Dies ist von Vorteil, weil so bei Leistungspendelungen mit hohen Frequenzen, also vielen Pendelvorgängen in kurzer Zeit, die Bestimmung der Kenngrößen mittels eines Zeitfensters von geringer Dauer auch besonders oft aktualisiert werden kann. Auf diese Weise bekommt beispielsweise eine Leitstelle noch aktuellere Informationen über Leistungspendelungen in ihrem Energieversorgungsnetz.

In einer anderen bevorzugten Ausführungsform des erfindungsgemäßen Verfahrens erfolgt die Bestimmung von Amplitude und Dämpfung der mindestens einen Leistungspendelung für jedes Zeitfenster jeweils mittels eines eigenen Datenverarbeitungszweigs. Dies ist vorteilhaft, weil hierdurch die Verarbeitungsgeschwindigkeit mittels einer Parallelisierung der Rechenvorgänge gesteigert wird.

In einer weiteren bevorzugten Ausführungsform des erfindungsgemäßen Verfahren umfassen die Datenverarbeitungszweige Datenverarbeitungsprozesse, die auf einer einzelnen Datenverarbeitungseinrichtung durchgeführt werden. Dies ist von Vorteil, weil die Verwendung von Datenverarbeitungsprozessen, beispielsweise einzelnen sogenannten "Threads", besonders einfach in einem Computer zu handhaben ist.

In einer anderen bevorzugten Ausführungsform des erfindungsgemäßen Verfahren umfassen die Datenverarbeitungszweige Datenverarbeitungseinrichtungen, insbesondere Prozessorkerne einer Multi-Prozessorkern-Datenverarbeitungsanordnung. Diese Variante ist dadurch vorteilhaft, dass Multi-Prozessorkern-Datenverarbeitungsanordnungen heute standardmäßig in üblichen Bürocomputern zur Verfügung stehen und sich eine Ausnutzung dieser Rechnerarchitektur zur Steigerung der Geschwindigkeit des erfindungsgemäßen Verfahrens anbietet.

Die Erfindung betrifft auch eine Datenverarbeitungsanordnung für die Bestimmung von Frequenz, Amplitude und Dämpfung mindestens einer Leistungspendelung in einem elektrischen Energieversorgungsnetz mit einem Speicher vorgegebener Speicherplatzgröße, in dem erfasste Momentanwerte der Leistung zur Bestimmung von Frequenz, Amplitude und Dämpfung der mindestens einen Leistungspendelung speicherbar sind; und mit einer Auswerteanordnung, die dazu eingerichtet ist, mit einem Zeitfenster von vorgegebener Dauer auf den Speicher zuzugreifen und Momentanwerte der Leistung auszulesen, und innerhalb des Zeitfensters erfasste Momentanwerte der Leistung zur Bestimmung von Frequenz, Amplitude und Dämpfung der mindestens einen Leistungspendelung zu verwenden.

Eine derartige Datenverarbeitungsanordnung ergibt sich aus dem oben genannten Stand der Technik.

Es ist die Aufgabe der Erfindung, eine gegenüber dem Stand der Technik verbesserte Datenverarbeitungsanordnung bereit zu stellen, die insbesondere eine genauere und schnellere Bestimmung von Frequenz, Amplitude und Dämpfung mindestens einer Leistungspendelung in einem elektrischen Energieversorgungsnetz ermöglicht.

Die Erfindung löst diese Aufgabe dadurch, dass die Auswerteanordnung weiterhin dazu eingerichtet ist, mindestens ein weiteres Zeitfenster zu verwenden, wobei alle Zeitfenster jeweils verschiedene Dauern aufweisen, und zur Bestimmung von Frequenz, Amplitude und Dämpfung jeweils dasjenige Zeitfenster zu benutzen, in dessen Dauer eine vorgegebene Anzahl von Pendelvorgängen der jeweiligen Leistungspendelung fällt.

Es ergeben sich für die erfindungsgemäße Datenverarbeitungsanordung sowie für die in den Unteransprüchen 11 bis 15 beanspruchten Ausführungsformen der Datenverarbeitungsanordnung sinngemäß die gleichen Vorteile wie eingangs für das erfindungsgemäße Verfahren beschrieben.

Zur Erläuterung der Erfindung zeigt in schematischer Darstellung die
- Figur: eine Leistungspendelung in einem elektrischen Energieversorgungsnetz, die mittels dreier Zeitfenster unterschiedlicher Dauer ausgewertet wird.

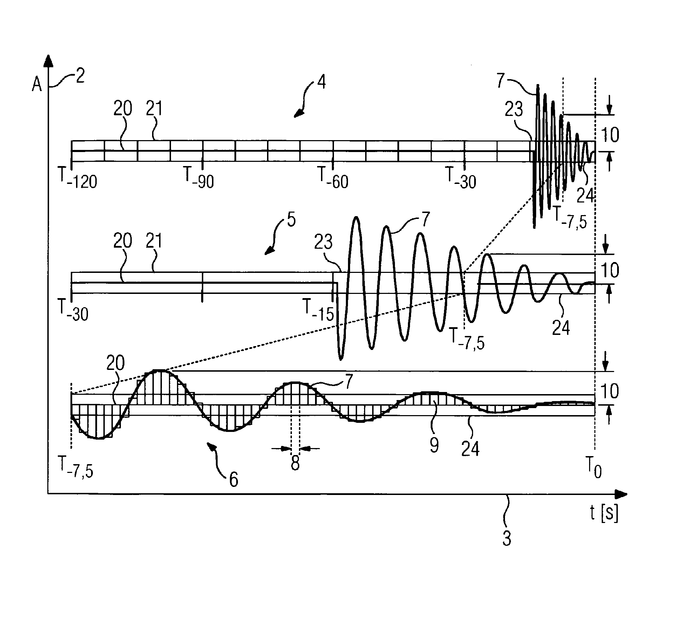

In der Figur ist eine Leistungspendelung 7 in einem elektrischen Energieversorgungsnetz in einer schematischen Darstellung gezeigt. Auf der Achse 3 ist die Zeit in Sekunden dargestellt, während auf der Achse 2 die Amplitude von Leistungspendelungen dargestellt ist. Es wird gezeigt, wie die Leistungspendelung 7 in drei unterschiedlichen Zeitfenstern 4,5,6 ausgewertet werden kann.

In dem obersten Zeitfenster 4 ist die Leistung 20 von einem Zeitpunkt T₋₁₂₀ bis zu einem Zeitpunkt T₀ dargestellt. Die Zeitdauer des Zeitfensters 4 umfasst also 120 Sekunden. Zur besseren Illustration ist die Zeitdauer in 16 Blöcke 21 mit je 7,5 Sekunden Dauer aufgeteilt. In den letzten beiden Blöcken 23,24 tritt eine Leistungspendelung 7 auf, die zunächst mit einer sehr großen Amplitude beginnt und zum Zeitpunkt T₀ hin stark gedämpft wird. Zum Zeitpunkt T_{-7,5}, also 7,5 Sekunden vor dem Ende des Zeitfensters, weist die Leistungspendelung 7 eine Amplitude 10 auf.

In dem zweiten Zeitfenster 5 sind nur die letzten 30 Sekunden, also der Zeitraum T₋₃₀ bis T₀ des Zeitfensters 4 dargestellt. Die Blöcke 21 haben die gleiche Dauer wie beim Zeitfenster 4. Zum Zeitpunkt T_{-7,5} weist die Leistungspendelung 7 wiederum eine Amplitude 10 auf.

In dem Zeitfenster 6 sind schließlich die letzten 7,5 Sekunden aus dem Zeitfenster 4 bzw. dem Zeitfenster 5 aufgetragen, also der Zeitraum T_{-7,5} bis T₀. In dem Zeitfenster 6 ist außerdem dargestellt, wie mit einer hohen Sampling-Rate, dargestellt durch den Verlauf der Leistungspendelung folgenden Kästchen 9 der Zeitdauer 8, eine sehr genaue Bestimmung der Messwerte für die Leistungspendelung gewährleistet ist.

Wie deutlich zu erkennen ist, umfasst die Leistungspendelung 7 in dem Zeitfenster 4 nur die letzten 15 Sekunden des Zeitfensters, mithin 2 von 16 Blöcken 21. Wird nun das Zeitfenster 4 zur Berechnung von Kenngrößen der Leistungspendelung 7 verwendet, so fließen sehr viele Messwerte in diese Auswertung der Kenngrößen ein, obwohl in dem Zeitraum T₋₁₂₀ bis T₋₁₅ keine Leistungspendelung in dem elektrischen Energieversorgungsnetz vorliegt. Die Bestimmung der Kenngrößen der Leistungspendelung 7 dauert folglich relativ lang und ist weniger genau, da die Leistungspendlung 7 nur zu einem geringen Anteil in die Gesamtdatenmenge der erfassten Leistungswerte 20 eingeht.

In dem Zeitfenster 5 wird nur ein Viertel der Dauer des Zeitfensters 4 betrachtet, woraus sich ergibt, dass die gleiche Leistungspendelung 7 nun zu der Hälfte der Leistungswerte, die innerhalb des Zeitfensters 5 erfasst werden, beiträgt. Die Bestimmung der Kenngrößen der Leistungspendelung 7 erfolgt daher um ein Vielfaches schneller und ist außerdem präziser als in dem Zeitfenster 4.

In dem Zeitfenster 6 kann die Leistungspendelung 7 noch schneller und noch genauer bestimmt werden, da hier nur die letzten 7,5 Sekunden der Leistungspendelung betrachtet werden und alle erfassten Momentanwerte der Leistung in Bezug zur Leistungspendelung 7 stehen.

Mit der hier beispielhaft dargestellten Leistungspendelung 7 ergibt sich bei Anwendung des erfindungsgemäßen Verfahrens also die Situation, dass drei unterschiedliche Zeitfenster Momentanwerte der Leistung erfassen und mit diesen Momentanwerten die Kenngrößen Frequenz, Amplitude und Dämpfung der Leistungspendelung bestimmt werden. Das Zeitfenster 6 ist besonders geeignet, um schnell und mit hoher Genauigkeit die Dämpfung und aktuelle Amplitude der Leistungspendelung 7 zu bestimmen. Deswegen werden bei dem erfindungsgemäßen Verfahren die mittels des Zeitfensters 6 bestimmten Dämpfungs- und Amplitudenwerte bereitgestellt.

In einem anderen Beispiel als dem hier gezeigten mit der Leistungspendelung 7, bei dem zum Beispiel eine Leistungspendelung besonders kleiner Frequenz vorkommt, könnte auch eines der anderen Zeitfenster 4,5 besser geeignet sein, um die Kenngrößen der Leistungspendelungen zu bestimmen. In dem Fall, dass mehrere sich überlagernde Leistungspendelungen vorliegen, könnte auch eine Kombination der verschiedenen Zeitfenster 4,5,6 geeignet sein, um schnell und mit hoher Genauigkeit die Dämpfung und Amplitude der Leistungspendelungen zu bestimmen. Dabei ist das Zeitfenster 4 besonders für Leistungspendelungen mit kleiner Frequenz geeignet, während das Zeitfenster 5 besonders für Leistungspendelungen mit mittelgroßer Frequenz geeignet ist; das Zeitfenster 6 schließlich ist besonders für Leistungspendelungen mit hoher Frequenz geeignet.

## Patentansprüche

1. Verfahren für die Bestimmung von Frequenz, Amplitude (10) und Dämpfung mindestens einer Leistungspendelung (7) in einem elektrischen Energieversorgungsnetz, bei dem
- ein Zeitfenster (4) von vorgegebener Dauer verwendet wird, und
- innerhalb des Zeitfensters erfasste Momentanwerte der Leistung (20) zur Bestimmung von Frequenz, Amplitude (10) und Dämpfung der mindestens einen Leistungspendelung (7) verwendet werden,
**dadurch gekennzeichnet, dass**
- mindestens ein weiteres Zeitfenster (5,6) verwendet wird, wobei alle Zeitfenster (4,5,6) jeweils verschiedene Dauern aufweisen, und zur Bestimmung von Frequenz, Amplitude (10) und Dämpfung jeweils dasjenige Zeitfenster (6) benutzt wird, in dessen Dauer eine vorgegebene Anzahl von Pendelvorgängen der jeweiligen Leistungspendelung fällt.

2. Verfahren nach Anspruch 1, bei dem die Zeitfenster jeweils eine auf häufig vorkommende Frequenzen von Leistungspendelungen (7) abgestimmte Dauer aufweisen.

3. Verfahren nach einem der vorhergehenden Ansprüche, bei dem die vorgegebene Anzahl die jeweils zur Bestimmung gerade noch ausreichende Anzahl von Pendelvorgängen der jeweiligen Leistungspendelung (7) ist.

4. Verfahren nach einem der vorhergehenden Ansprüche, bei dem die erfassten Momentanwerte (20) in einem Speicher mit einer Speicherplatzgröße gespeichert werden, die das Speichern der im längsten Zeitfenster (4) erfassten Momentanwerte (20) gestattet.

5. Verfahren nach einem der vorhergehenden Ansprüche, bei dem die Bestimmung von Amplitude und Dämpfung regelmäßig zu vorgegebenen Zeitpunkten wiederholt wird.

6. Verfahren nach Anspruch 5, bei dem, wenn bereits mindestens eine Leistungspendelung (7) erkannt wurde, der zeitliche Abstand der vorgegebenen Zeitpunkte verringert wird, wenn die erkannte mindestens eine Leistungspendelung (7) eine hohe Frequenz aufweist.

7. Verfahren nach einem der vorhergehenden Ansprüche, bei dem die Bestimmung von Amplitude und Dämpfung der mindestens einen Leistungspendelung (7) für jedes Zeitfenster (4,5,6) jeweils mittels eines eigenen Datenverarbeitungszweigs erfolgt.

8. Verfahren nach Anspruch 7, bei dem die Datenverarbeitungszweige Datenverarbeitungsprozesse, die auf einer einzelnen Datenverarbeitungseinrichtung durchgeführt werden, umfassen.

9. Verfahren nach Anspruch 7, bei dem die Datenverarbeitungszweige Datenverarbeitungseinrichtungen, insbesondere Prozessorkerne einer Multi-Prozessorkern-Datenverarbeitungsanordnung, umfassen.

10. Datenverarbeitungsanordnung für die Bestimmung von Frequenz, Amplitude und Dämpfung mindestens einer Leistungspendelung in einem elektrischen Energieversorgungsnetz, mit
- einem Speicher vorgegebener Speicherplatzgröße, in dem erfasste Momentanwerte der Leistung zur Bestimmung von Frequenz, Amplitude und Dämpfung der mindestens einen Leistungspendelung speicherbar sind, und
- einer Auswerteanordnung, die dazu eingerichtet ist, mit einem Zeitfenster von vorgegebener Dauer auf den Speicher zuzugreifen und Momentanwerte der Leistung auszulesen, und innerhalb des Zeitfensters erfasste Momentanwerte der Leistung zur Bestimmung von Frequenz, Amplitude und Dämpfung der mindestens einen Leistungspendelung zu verwenden, **dadurch gekennzeichnet, dass**
- die Auswerteanordnung weiterhin dazu eingerichtet ist, mindestens ein weiteres Zeitfenster zu verwenden, wobei alle Zeitfenster jeweils verschiedene Dauern aufweisen, und zur Bestimmung von Frequenz, Amplitude und Dämpfung jeweils dasjenige Zeitfenster zu benutzen, in dessen Dauer eine vorgegebene Anzahl von Pendelvorgängen der jeweiligen Leistungspendelung fällt.

11. Datenverarbeitungsanordnung nach Anspruch 10, bei der die Auswerteanordnung derart ausgebildet ist, dass die Dauern der weiteren Zeitfenster jeweils auf häufig vorkommende Frequenzen von Leistungspendelungen abstimmbar sind.

12. Datenverarbeitungsanordnung nach einem der Ansprüche 10 oder 11, bei der die Auswerteanordnung derart ausgebildet ist, dass die vorgegebene Anzahl die jeweils zur Bestimmung gerade noch ausreichende Anzahl von Pendelvorgängen der jeweiligen Leistungspendelung ist.

13. Datenverarbeitungsanordnung nach einem der Ansprüche 10 bis 12, bei dem die Speicherplatzgröße das Speichern der im längsten Zeitfenster erfassten Momentanwerte gestattet.

14. Datenverarbeitungsanordnung nach einem der Ansprüche 10 bis 13, bei der die Auswerteanordnung dazu eingerichtet ist, die Bestimmung von Amplitude und Leistung regelmäßig zu vorgegebenen Zeitpunkten zu wiederholen und, wenn bereits mindestens eine Leistungspendelung erkannt wurde, den zeitlichen Abstand der vorgegebenen Zeitpunkte zu verringern, wenn die erkannte mindestens eine Leistungspendelung eine hohe Frequenz aufweist.

15. Datenverarbeitungsanordnung nach einem der Ansprüche 10 bis 14 mit mehreren Datenverarbeitungszweigen, insbesondere mehreren Prozessorkernen einer Multi-Prozessorkern-Datenverarbeitungsanordnung, wobei für die Bestimmung von Amplitude und Dämpfung der mindestens einen Leistungspendelung für jedes Zeitfenster jeweils ein eigener Datenverarbeitungszweig vorgesehen ist.

## Claims

1. Method for determining the frequency, amplitude (10), and attenuation of at least one output oscillation (7) in an electrical energy supply network, in which
- a time window (4) having a predefined duration is used, and
- instantaneous values of the output (20) detected within the time window are used for determining the frequency, amplitude (10), and attenuation of the at least one output oscillation (7),
**characterized in that**
- at least one additional time window (5, 6) is used, wherein all time windows (4, 5, 6) each have different durations, and that time window (6) within whose duration a predefined number of oscillation processes of the particular output oscillation falls is used in each case for determining the frequency, amplitude (10), and attenuation.

2. Method according to Claim 1, in which the time windows have a duration which is adapted in each case to frequently occurring frequencies of output oscillations (7).

3. Method according to one of the preceding claims, in which the predefined number is the number of oscillation processes of the particular output oscillation (7) which is barely sufficient in each case for carrying out the determination.

4. Method according to one of the preceding claims, in which the detected instantaneous values (20) are stored in a memory having a memory size which permits the storage of the instantaneous values (20) detected in the longest time window (4).

5. Method according to one of the preceding claims, in which the determination of the amplitude and attenuation is repeated regularly at predefined points in time.

6. Method according to Claim 5, in which, if at least one output oscillation (7) has already been detected, the time interval of the predefined points in time is reduced if the at least one output oscillation (7) detected has a high frequency.

7. Method according to one of the preceding claims, in which the determination of amplitude and attenuation of the at least one output oscillation (7) is carried out for each time window (4, 5, 6) with the aid of a separate processing branch in each case.

8. Method according to Claim 7, in which the data processing branches comprise data processing operations which are carried out on a single data processing device.

9. Method according to Claim 7, in which the processing branches comprise data processing devices, in particular processor cores of a multiprocessor core data processing system.

10. Data processing system for determining the frequency, amplitude, and attenuation of at least one output oscillation in an electrical energy supply network, including
- a memory having a predefined memory size, in which detected instantaneous values of the output may be stored for determining the frequency, amplitude, and attenuation of the at least one output oscillation, and
- an evaluation system which is designed to access the memory and to read out instantaneous values of the output using a time window having a predefined duration, and to use instantaneous values of the output detected within the time window for determining the frequency, amplitude, and attenuation of the at least one output oscillation, **characterized in that**
- the evaluation system is furthermore configured to use at least one additional time window, wherein all time windows each have different durations, and to use that time window within whose duration a predefined number of oscillation processes of the particular output oscillation falls in each case for determining the frequency, amplitude, and attenuation.

11. Data processing system according to Claim 10, in which the evaluation system is designed in such a way that the durations of the additional time windows may be adapted in each case to frequently occurring frequencies of output oscillations.

12. Data processing system according to one of Claims 10 or 11, in which the evaluation system is designed in such a way that the predefined number is the number of oscillation processes of the particular output oscillation which is barely sufficient in each case for carrying out the determination.

13. Data processing system according to one of Claims 10 to 12, in which the memory size permits the storage of the instantaneous values detected in the longest time window.

14. Data processing system according to one of Claims 10 to 13, in which the evaluation system is configured to repeat the determination of amplitude and output regularly at predefined points in time and, if at least one output oscillation has already been detected, to reduce the time interval of the predefined points in time if the at least one output oscillation detected has a high frequency.

15. Data processing system according to one of Claims 10 to 14 including multiple data processing branches, in particular, multiple processor cores of a multiprocessor core data processing system, wherein a separate data processing branch is provided in each case for determining the amplitude and attenuation of the at least one output oscillation for each time window.

## Revendications

1. Procédé de détermination de la fréquence, de l'amplitude (10) et de l'amortissement d'au moins une oscillation (7) de puissance dans un réseau d'alimentation en énergie électrique, dans lequel
- on utilise une fenêtre (4) de temps de durée donnée à l'avance et
- on utilise des valeurs instantanées, détectées dans la fenêtre de temps, de la puissance (20) pour la détermination de la fréquence, de l'amplitude (10) et de l'amortissement de la au moins une oscillation de puissance, **caractérisé en ce que**
- on utilise au moins une autre fenêtre (5, 6) de temps, toutes les fenêtres (4, 5, 6) de temps ayant respectivement des durées différentes, et on utilise, pour la détermination de la fréquence, de l'amplitude (10) et de l'amortissement, respectivement la fenêtre (6) de temps, dont la durée de laquelle tombe un nombre donné à l'avance de processus d'oscillation de l'oscillation de puissance respective.

2. Procédé suivant la revendication 1, dans lequel les fenêtres de temps ont respectivement une durée adaptée aux fréquences, se produisant le plus souvent, des oscillations (7) de puissance.

3. Procédé suivant l'une des revendications précédentes, dans lequel le nombre donné à l'avance est le nombre juste encore suffisant pour la détermination de processus d'oscillation de l'oscillation (7) de puissance respective.

4. Procédé suivant l'une des revendications précédentes, dans lequel on mémorise des valeurs (20) instantanées détectées dans une mémoire, ayant une dimension d'emplacement de mémoire, qui autorise la mémorisation des valeurs (20) instantanées détectées dans la fenêtre (4) de temps la plus longue.

5. Procédé suivant l'une des revendications précédentes, dans lequel on répète la détermination de l'amplitude et de l'amortissement régulièrement à des instants donnés à l'avance.

6. Procédé suivant la revendication 5, dans lequel, lorsque l'on a déjà reconnu au moins une oscillation (7) de puissance, on diminue la distance dans le temps entre des instants donnés à l'avance, si la au moins une oscillation (7) de puissance reconnue a une fréquence haute.

7. Procédé suivant l'une des revendications précédentes, dans lequel la détermination de l'amplitude et de l'amortissement de la au moins une oscillation (7) de puissance s'effectue pour chaque fenêtre (4, 5, 6) de temps au moyen de sa propre branche de traitement de données.

8. Procédé suivant la revendication 7, dans lequel les branches de traitement de données comprennent des processus de traitement de données qui sont effectués sur un dispositif de traitement de données isolément.

9. Procédé suivant la revendication 7, dans lequel les branches de traitement de données comprennent des dispositifs de traitement de données, notamment des noyaux de processeur d'un dispositif de traitement de données à noyau de processeur multiple.

10. Dispositif de traitement de données pour la détermination de la fréquence, de l'amplitude et de l'amortissement d'au moins une oscillation de puissance dans un réseau d'alimentation en énergie électrique, comprenant
- une mémoire d'une dimension d'emplacement de mémoire donnée à l'avance, dans laquelle des valeurs instantanées détectées de la puissance peuvent être mémorisées pour la détermination de la fréquence, de l'amplitude et de l'amortissement de la au moins une oscillation de puissance et
- un dispositif d'exploitation conçu pour accéder à la mémoire dans une fenêtre de temps d'une durée donnée à l'avance et déchiffrer des valeurs instantanées de la puissance et pour utiliser des valeurs instantanées, détectées dans la fenêtre de temps, de la puissance, pour la détermination de la fréquence, de l'amplitude et de l'amortissement de la au moins une oscillation de puissance,
**caractérisé en ce que**
- le dispositif d'exploitation est conçu, en outre, pour utiliser au moins une autre fenêtre de temps, toutes les fenêtres de temps ayant des durées respectivement différentes et pour utiliser, pour la détermination de la fréquence, de l'amplitude et de l'amortissement, respectivement la fenêtre de temps, dont la durée de laquelle tombe un nombre donné à l'avance de processus d'oscillation de l'oscillation de puissance respective.

11. Dispositif de traitement de données suivant la revendication 10, dans lequel le dispositif d'exploitation est constitué de manière à ce que les durées des autres fenêtres de temps puissent être adaptées respectivement aux fréquences, se produisant le plus souvent, des oscillations de puissance.

12. Dispositif de traitement de données suivant l'une des revendications 10 ou 11, dans lequel le dispositif d'exploitation est constitué de manière à ce que le nombre donné à l'avance soit le nombre, juste encore suffisant pour la détermination, de processus d'oscillation de l'oscillation de fréquence respective.

13. Dispositif de traitement de données suivant l'une des revendications 10 à 12, dans lequel la dimension de l'emplacement de mémoire autorise la mémorisation des valeurs instantanées détectées dans la fenêtre de temps la plus longue.

14. Dispositif de traitement de données suivant l'une des revendications 10 à 13, dans lequel le dispositif d'exploitation est conçu pour répéter la détermination de l'amplitude et de la puissance régulièrement à des instants donnés à l'avance et, lorsqu'au moins une oscillation de puissance a déjà été reconnue, pour diminuer la distance dans le temps entre les instants donnés à l'avance, si la au moins une oscillation de puissance reconnue a une fréquence haute.

15. Dispositif de traitement de données suivant l'une des revendications 10 à 14, comprenant plusieurs branches de traitement de données, notamment plusieurs noyaux de processeur d'un dispositif de traitement de données à noyau de processeur multiple, dans lequel, pour la détermination de l'amplitude et de l'amortissement de la au moins une oscillation de puissance, il est prévu, pour chaque fenêtre de temps respectivement, sa propre branche de traitement de données.
